# EUROPEAN PATENT APPLICATION

(11) **EP 1 667 267 A2**
(43) Date of publication of application: **07.06.2006**
(21) Application number: 05077090.8
(22) Date of filing: 15.09.2005
(51) Int. Cl.: H01M 8/02, H01M 8/10

(54) **A fuel cell built-in serial/parallel connecting mechanism**

(30) Priority: 28.09.2004 CN 04296255 U
(71) Applicant: Antig Technology Co., Ltd., 114 Taipei (TW)
(72) Inventor: Shu, His-Ming, SinJhuang City Taipei (TW); Chang, Tsang-Ming, Taipei (TW); Deng, Feng-Yi, Taipei (TW); Shen, Ko-Chen, NeiHu, Taipei (TW)
(74) Representative: De Pablos Riba, Julio

(57) **Abstract**

The present invention is a fuel cell having built-in serial/parallel connecting mechanism. The anode circuit board comprises anode current collection circuitries and anode solder pads placed on the peripheral of the anode circuit board. The cathode circuit board comprises cathode current collection circuitries and cathode solder pads placed on the peripheral of the anode circuit board. The placed positions of the cathode solder pads are one-by-one opposite to the placed position of the anode solder pad. At least above one membrane electrode assembly (MEA) is close and sandwiched between the anode circuit board and the cathode circuit board, and again the MEAs are respectively one-by-one sandwiched between the anode current collection circuitries and the corresponding cathode current collection circuitries.

## Description

### FIELD OF THE INVENTION

The present invention is related to a fuel cell, especially to a fuel cell having serial/parallel connecting mechanism for serial/parallel connecting to each membrane electrode assembly (MEA).

### BACKGROUND OF THE INVENTION

The conventional fuel cell is to use serial/parallel connecting via holes as the means to serial/parallel connect each MEA, and although the fuel cell manufactured by the print circuit board (PCB) process using via hole means is convenient, the MEA itself being fragile and again processed by filling the conductive material into the via hole in the PCB process will damage the MEA in this stage as a result of having enormous impact to the yield of manufacturing the fuel cell.

The inventor investigates the above used disadvantages and desires to improve and invent a fuel cell having the solder pads placed along the board peripheral for serial/parallel connecting to the MEAs to overcome the above used disadvantages.

### SUMMARY OF THE INVENTION

The main object of the present invention is to provide a fuel cell having a built-in serial/parallel connecting mechanism to possibly protect the MEAs from the damage in the process of serial/parallel connecting to each MEA.

To achieve the above object, the present invention provides a fuel cell having built-in serial/parallel connecting mechanism comprising the anode circuit board comprises at least above one anode current collection circuitry and above one anode solder pad wherein the anode current collection circuitries respectively one-by-one electrically connect to the anode solder pads and the anode solder pads are placed on the peripheral of the anode circuit board. The cathode circuit board comprises at least above one cathode current collection circuitry and above one cathode solder pad wherein the cathode current collection circuitries respectively one-by-one electrically connect to the cathode solder pads and the cathode solder pads are placed on the peripheral of the anode circuit board. The placed positions of the cathode solder pads are one by one opposite to the placed positions of the anode solder pads. At least above one membrane electrode assembly (MEA) is close and sandwiched between the anode circuit board and the cathode circuit board, and again the MEAs are respectively one-by-one sandwiched between the anode current collection circuitries and the corresponding cathode current collection circuitries.

The present invention design is innovative and useful in the industry for the improvement so as to apply and disclose the invention. In order to make the people familiar with the art understand the objects, characteristics and improvements, the present invention is detailed described in below by way of the following embodiments and attached figures.

### BRIEF DESCRIPTION OF THE DRAWINGS

These and other modifications and advantages will become even more apparent from the following detained description of a preferred embodiment of the invention and from the drawings in which:
Figure 1 shows the appearance figure of the present invention fuel cell built-in serial/parallel connecting mechanism;
Figure 2 shows the decomposed figure of the present invention fuel cell built-in serial/parallel connecting mechanism;
Figure 3A shows the present invention fuel cell serial connecting to all MEAs, wherein the cathode serial/parallel connecting cooper circuitries located at the cathode circuit board are a layout example;
Figure 3B shows the present invention fuel cell serial connecting to all MEAs, wherein the anode serial/parallel connecting cooper circuitries located at the anode circuit board are a layout example; and
Figure 4 shows the decomposed figure of another modified embodiment of the present invention fuel cell built-in serial/parallel connecting mechanism.

### DETAILED DESCRIPTION OF THE INVENTION

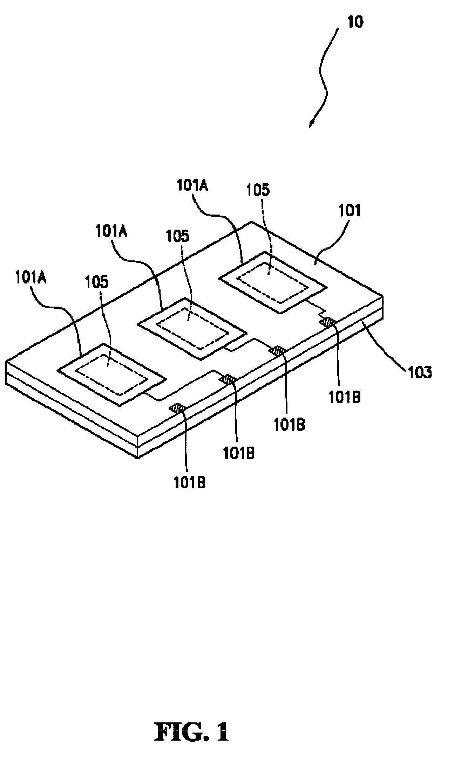

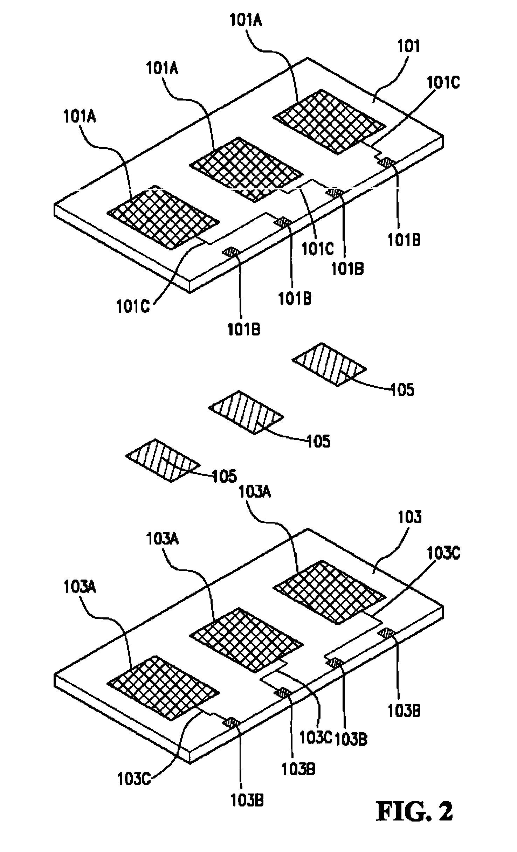

Figure 1 shows the appearance figure of the present invention fuel cell having built-in serial/parallel connecting mechanism and Figure 2 shows the decomposed figure of the present invention fuel cell built-in serial/parallel connecting mechanism. The present invention fuel cell 10 having built-in serial/parallel connecting mechanism mainly comprises cathode circuit board 101, anode circuit board 103 and at least above one membrane electrode assembly (MEA) 105. Cathode circuit board 101 and anode circuit board 103 are capable of using the PCB as the material and using the PCB process to form at least above one cathode current collection circuitry 101A, above one anode current collection circuitry 103A, at least above one cathode solder pad 101B, at least above one anode solder pad 103B, cathode serial/parallel cooper circuitries 101C and anode serial/parallel cooper circuitries 103C respectively upon the cooper foil of cathode circuit board 101 and the cooper foil of anode circuit board 103. The present invention particularly places cathode solder pads 101B and anode solder pads 103B respectively on the peripheral of cathode circuit board 101 and anode circuit board 103, and the cathode solder pads 101B and the anode solder pads 103B are positioned on both up and down opposite sides. The present invention further uses cathode serial/parallel cooper circuitries 101C and anode serial/parallel cooper circuitries 103C to respectively connect cathode current collection circuitries 101A one-by-one to cathode solder pads 101B and connect anode collection circuitries 103A one-by-one to anode solder pads 103B.

In assembling the present invention fuel cell 10, it first respectively aligns and places each MEA 105 between each pair of up and down correspondingly opposite cathode current collection circuit 101A and anode current collection circuitry 103A, and then piles sequentially in layer laminations of cathode circuit board 101, MEAs 105 and anode circuit board 103 together from top to down.

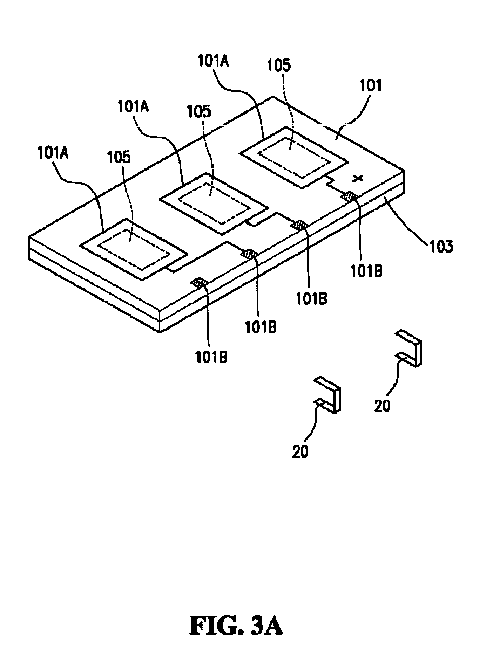

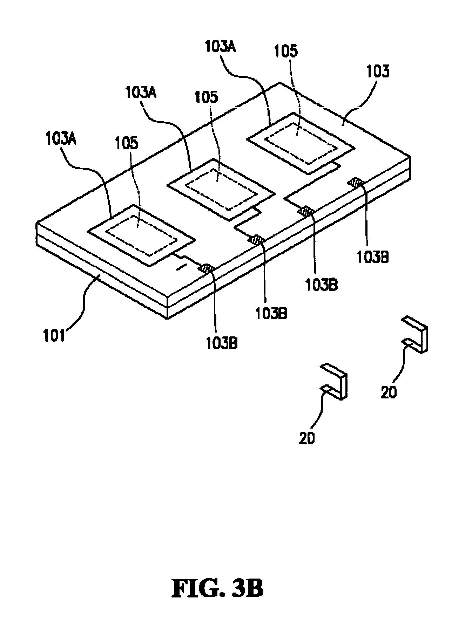

According to the future serial or parallel connecting art used for MEAs 105 in the plan of designing cooper circuitry connections, the present invention cathode serial/parallel cooper circuitries 101C and anode serial/parallel cooper circuitries 103C are able to be layout. Referring to FIG. 3A showing the present invention fuel cell serial connecting to all MEAs wherein the cathode serial/parallel connecting cooper circuitries 101C located at the cathode circuit board 101 is a layout example. Referring to FIG. 3B showing the present invention fuel cell serial connecting to all MEAs where in the anode serial/parallel connecting cooper circuitries 103C located at the anode circuit board 103 is a layout example. The cathode serial/parallel cooper circuitries 101C and the anode serial/parallel cooper circuitries 103C are respectively serial connecting MEAs 105, cathode solder pads 101B and anode solder pads 103B.

The present invention uses a U shape metallic piece to clip each pair of cathode solder pad 101B and anode solder pad 103B on top and down opposite sides and then solders to fix U shape metallic piece 20, cathode solder pad 101B and anode solder pad 103B in order to connect and electrically conduct each pair of cathode solder pad 101B and anode solder pad 103B on top and down opposite sides. The notation of "+" in FIG. 3A denotes the positive electrode after serial connecting MEAs 105, and the notation of "-" in FIG 3B denotes the negative electrode after serial connecting MEAs 105.

Those people skillful the art understanding the present invention is to implement the serial/parallel connecting mechanism of MEAs 105 by cathode solder pads 101B, anode solder pads 103B, cathode serial/parallel copper circuitries 101C, anode serial/parallel cooper circuitries 103C and metallic pieces 20, and those people familiar with the art want to have any modification by changing the connections different from FIG. 3A and FIG. 3B, the modification still belongs to the present invention's scope.

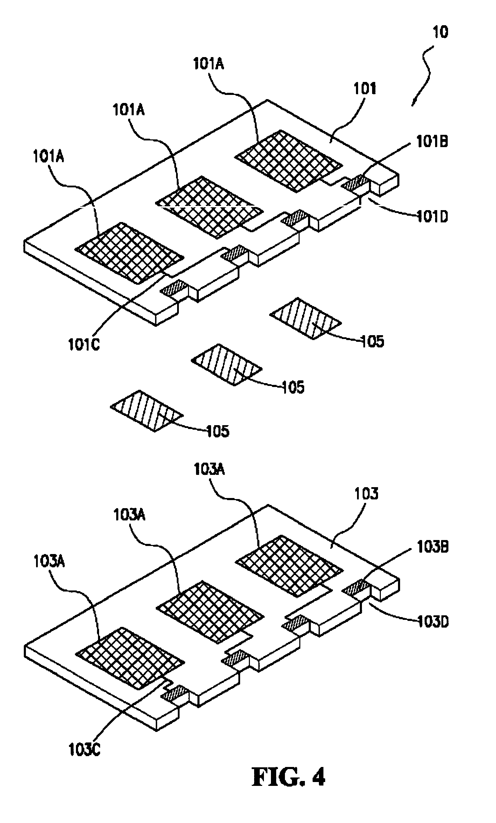

Figure 4 shows the decomposed figure of another modified embodiment of the present invention fuel cell built-in serial/parallel connecting mechanism. The present invention respectively forms notches on the peripheral areas 101D and 103D adjacent to each cathode solder pad 101B and each anode solder pad 103B. When cathode circuit board 101, MEAs 105 and anode circuit board 103 are connected, the peripheral areas 101D and 103D containing each pair of cathode solder pad 101B and anode solder pad 103B on up and down opposite sides will form a connected notch. Furthermore, the present invention forms the conductive material over the wall of the connected notch on peripheral area 101D and 103D to connect and electrically conduct cathode solder pad 101B and anode solder pad 103B.

Furthermore, the present invention cathode current collection circuitries 101A and anode current collection circuitries 103A are possible to be respectively placed plural via holes (not shown in the figures) and make the cathode fuel and anode fuel respectively flow into cathode and anode of each MEA105 by these via holes. The present invention cathode circuit board 101 and anode circuit board 103 are possible to use double-sided cooper PCB and respectively form cathode current collection circuitries 101A and anode current collection circuitries 103A in up and down correspondingly and electrical conduction on the top surface and bottom surface.

The present invention fuel cell built-in serial/parallel connection mechanism covers the following merits and significant improvements:
1. The present invention places solder pads for serial/parallel connecting MEAs on the board peripheral to make serial/parallel connecting MEAs much easier; and
2. The present invention is totally different from the prior art using serial/parallel connecting MEAs by via holes, the prior art in the process of filling the solder or other conductive material into the via hole will damage the fuel cell, however, the present invention fully eliminates this disadvantage.

The above described embodiments are examples for convenient interpretations; the rights scope claimed by the present invention is based on the following claims and not limited by the above embodiments.

## Claims

1. A fuel cell built-in serial/parallel connecting mechanism, comprising:
an anode circuit board, comprising at least above one anode current collection circuitry and above one anode solder pad wherein the anode current collection circuitries respectively one-by-one electrically connect to the anode solder pads and the anode solder pads are placed on the board peripheral of the anode circuit board; a cathode circuit board, comprising at least above one cathode current collection circuitry and above one cathode solder pad wherein the cathode current collection circuitries respectively one-by-one electrically connect to the cathode solder pads and the cathode solder pads are placed on the board peripheral of the cathode circuit board and the placed positions of the cathode solder pads are one-by-one opposite to the placed positions of the anode solder pads;
at least above one MEA, being close and sandwiched between the anode circuit board and the cathode circuit board, and again the MEAs being respectively one-by-one sandwiched between the anode current collection circuitries and the corresponding cathode current collection circuitries.

2. The fuel cell built-in serial/parallel connecting mechanism of claim 1, wherein the peripheral area adjacent to the anode solder pad is placed as a notch shape.

3. The fuel cell built-in serial/parallel connecting mechanism of claim 1, wherein the peripheral area adjacent to the cathode solder pad is placed as a notch shape.

4. The fuel cell built-in serial/parallel connecting mechanism of claim 1, further comprising anode serial/parallel cooper circuitries formed on the anode circuit board and used to respectively one-by-one electrically connect the anode current collection circuitries to the anode solder pads.

5. The fuel cell built-in serial/parallel connecting mechanism of claim 1, further comprising cathode serial/parallel cooper circuitries formed on the cathode circuit board and used to respectively one-by-one electrically connect the cathode current collection circuitries to the cathode solder pads.
